# EUROPEAN PATENT SPECIFICATION

(11) **EP 2 592 651 B1**
(45) Date of publication and mention of the grant of the patent: **10.07.2019**
(21) Application number: 12191798.3
(22) Date of filing: 08.11.2012
(51) Int. Cl.: H01L 23/473

(54) **Heat dissipating module**
Wärmeableitendes Modul
Module de dissipation de chaleur

(30) Priority: 08.11.2011 TW 100140735
(43) Date of publication of application: 15.05.2013
(73) Proprietor: Chen, Huang-Han, 241 New Taipei City (TW)
(72) Inventor: Chen, Huang-Han, 241 New Taipei City (TW)
(74) Representative: Viering, Jentschura & Partner mbB Patent- und Rechtsanwälte

(56) References cited:
- DE-A1- 1 639 047
- JP-A- 2004 095 599
- JP-A- 2007 012 719
- JP-A- 2008 103 400
- US-A- 5 193 611
- US-A- 6 014 312
- US-A1- 2007 246 204
- US-B1- 6 257 320

## Description

### BACKGROUND OF THE INVENTION

### Field of the Invention

The invention relates to a heat dissipating module. More particularly, the invention relates to a heat dissipating module having a preferred heat dissipating efficiency for a heat source.

### Description of Related Art

In recent years, with the enormous progress of the computer technology, the operating speed of the computer is continuously increased, and the heat generation rate of electronic elements within a computer host continuously rises correspondingly. In order to prevent the electronic elements within the computer host from overheating to cause a temporary or permanent failure to the electronic element, how to provide sufficient heat dissipating performance to the electronic elements within the computer is accordingly important.

For example, in a computer system, for example, a center process unit (CPU), a north bridge chip, a south bridge chip, or other heat generating elements are disposed on a mother board. In the prior art, in order to remove the heat on the mother board generated during the high speed operation, a heat dissipating module is usually disposed on these heat generating elements for performing the heat dissipation.
JP 2008 103 400 A discloses a watercooled heat sink that has a first plate having a pair of communicating holes at both the ends in the longitudinal direction, and a second plat that communicates with respective communicating holes and is formed in a frame. An end plate is arranged at both the edge positions in the lamination direction for composing a core. Inlet and outlet ports of cooling water are connected to the communicating holes.
US 6 014 312 A discloses a cooler for use as a heat sink for electrical components or circuits consisting of several cooler layers which are joined flat to one another, which are stacked on top of one another, which form channels through which coolant flows. US 5 193 611 A discloses a heat exchanger including a plurality of fluid pathways in which at least some are defined between surfaces of unperforated primary plates. Between the primary plates are at least two secondary perforated plates extending along the fluid pathway with perforations in adjacent plates being staggered. Adjacent secondary and primary sheets are in contact such that conducting pathways are formed extending between the two primary surfaces while areas of secondary plates not in contact with other secondary plates constitute secondary surfaces.
DE 16 39 047 A1 discloses a cooling body through which a coolant can flow from an inlet to an outlet.
US 6 257 320 B1 discloses a fluid cooled heat sink device suitable for use with a semiconductor especially in high power systems including a heat sink member having a plurality of interior walls defining a plurality of passageways for a cooling fluid, with the heat sink member having an essentially flat surface and with the passageways being in heat exchange relationship with the flat surface. The passageways define a plurality of paths for cooling fluid with wide channel areas adjacent the flat surface.
JP 2004 095599 A discloses a stacked cooler having edge-side apertures and intermediate apertures. Outer plates 120, 130 are stacked up on both outer sides of a stack of intermediate plates. The edge-side apertures and the intermediate apertures intercommunicate with each other, and the intercommunication results in the formation of a plurality of connection channels connecting edge-side channels extend along both edge sides enabling a cooling liquid to circulate for the cooling of a heat-producing body attached to the surface of the outer plates.
JP 2007 012719 A discloses a liquid-cooling micro channel type cooler, of which the flow channel is flexibly designed. In the cooler, metal foil is stacked to form plate-like or sheet-like laminates in a plurality of numbers to form a stacked structure. The stacked structure comprises a plurality of parallel micro channels in which a coolant flows inside.
US 2007/246204 A1 discloses a liquid cooling device including a base, a housing and a heat exchanger. The base and the housing enclose a chamber which receives the heat exchanger therein. Inlet and outlet for liquid are provided at the housing. The heat exchanger includes stacked flakes. Each flake includes parallel and alternately arranged first and second strips each having a void defined therein. The flakes are stacked in a manner such that each first strip overlays and abuts against a corresponding second strip of an adjacent flake and that the void in each first strip and the void in the corresponding second strip of the adjacent flake are in fluid communication with each other to thereby form a channel between the inlet and the outlet.

### SUMMARY OF THE INVENTION

The invention is directed to a heat dissipating module having larger contacting area with a working fluid to have a preferred heat-dissipation efficiency for a heat source.

According to the invention, a heat dissipating module according to claim 1 is provided. The heat dissipating module is adapted to be disposed on a heat source and to heat dissipate for the heat source. The heat dissipating module includes a plurality of first heat dissipating fins and a plurality of second heat dissipating fins, the first heat dissipating fins and the second heat dissipating fins are combined with each other. Each first heat dissipating fin has a first body and a plurality of first heat dissipating groove assemblies arranged in the first body along a first direction, wherein each first heat dissipating groove assembly has a plurality of first heat dissipating grooves unit arranged in the first body along a second direction. Each second heat dissipating fin has a second body and a plurality of second heat dissipating groove assemblies arranged in the second body along the first direction, wherein each second heat dissipating groove assembly has a plurality of second heat dissipating groove units arranged in the second body along the second direction.

The first heat dissipating fins and the second heat dissipating fins are combined with each other, one end of the first heat dissipating groove unit of each first heat dissipating fin is overlapped with one end of one second heat dissipating groove unit of one second heat dissipating fin adjacent to the first heat dissipating fin, another end of the first heat dissipating groove unit is overlapped with one end of another second heat dissipating groove unit, and the two second heat dissipating groove units overlapped with the first heat dissipating groove unit are adjacent and arranged in the second body along the second direction, wherein each first heat dissipating groove assembly and each second heat dissipating groove assembly have two end portions respectively, and two of the end portions are communicated with an inlet channel and an outlet channel respectively.

At least one of each first heat dissipating fin and each second heat dissipating fin has at least one communicating structure, the communicating structure of each first heat dissipating fin is adapted to communicate with two adjacent second heat dissipating groove assemblies of each second heat dissipating fin, the communicating structure of each second heat dissipating fin is adapted to communicate with two adjacent first heat dissipating groove assemblies of each first heat dissipating fin. The first heat dissipating groove units of one first heat dissipating groove assembly and the first heat dissipating groove units of another first heat dissipating groove assembly adjacent thereto are interlaced with each other respectively, and the second heat dissipating groove units of one second heat dissipating groove assembly and the second heat dissipating groove units of another second heat dissipating groove assembly adjacent thereto are interlaced with each other respectively. The first heat dissipating grooves unit of each first heat dissipation fin are without overlap and the second heat dissipating grooves unit of each second heat dissipation fin are without overlap. One end portion of the first heat dissipating groove unit is partial overlapped with one end portion of the second heat dissipating groove unit. The first heat dissipating fins are combined with the second heat dissipating fins along a fabricating direction with each other, and the first direction, the second direction, and the fabricating direction are vertical with each other. The first body of each first heat dissipating fin has a first heat contacting side, and the second body of each second heat dissipating fin has a second heat contacting side. When the first heat dissipating fins and the second heat dissipating fins are combined with each other, constructing a heat contacting surface by these first heat contacting sides and these second heat contacting sides for contacting to the heat source. Each first heat dissipating groove unit and each second heat dissipating groove unit is a diamond structure, and at least an inclined plane is configured in the inner wall of each first and second heat dissipating groove unit. An included angle between the inclined inner plane and the heat contacting surface is an acute or obtuse angle.

In one embodiment of the present invention, wherein the inlet channel, the first heat dissipating groove assemblies, the second heat dissipating groove assemblies, and the outlet channel are communicated with each other to form a heat dissipating channel.

In one embodiment of the present invention, wherein the communicating structure of each first heat dissipating fin is further communicated with two second heat dissipating groove units of the second heat dissipating fin adjacent to first heat dissipating fin, and the two second heat dissipating groove units are adjacent and arranged along the first direction or the second direction, and the communicating structure of each second heat dissipating fin is further communicated with two first heat dissipating groove units of the first heat dissipating fin adjacent to the second heat dissipating fin, and the two first heat dissipating groove units are adjacent and arranged along the first direction or the second direction.

In one embodiment of the present invention, wherein each first heat dissipating fin and each second heat dissipating fin have a inlet guiding groove and a outlet guiding groove respectively, the inlet guiding grooves are formed to be the inlet channel, the outlet guiding grooves are formed to be the outlet channel.

In one embodiment of the present invention, the heat dissipating module further comprises a inlet joint and a outlet joint, and the first body of partial of the first heat dissipating fins and the second body of partial of the second heat dissipating fins have a inlet concave and a outlet concave, the inlet concaves are formed to be a inlet connecting space, the outlet concaves are formed to be a outlet connecting space, one side of the inlet connecting space is communicated with the inlet joint, another side of the inlet connecting space is communicated with the inlet channel, one side of the outlet connecting space is communicated with the outlet joint, another side of the outlet connecting space is communicated with the outlet channel.

In one embodiment of the present invention, wherein each inlet concave is communicated with the corresponding inlet guiding groove, each outlet concave is communicated with the corresponding outlet guiding groove.

In one embodiment of the present invention, wherein the combination of the first heat dissipating fins and the second heat dissipating fins is fabricated on the heat source along the first direction, and the inlet channel is communicated with the end portion of the first heat dissipating groove assembly adjacent to the heat source or the end portion of the second heat dissipating groove assembly adjacent to the heat source, the outlet channel is communicated with the end portion of the first heat dissipating groove assembly away from the heat source or the end portion of the second heat dissipating groove assembly away from the heat source.

In one embodiment of the present invention, wherein the first heat dissipating groove assemblies and the second heat dissipating groove assemblies are corresponding with each other, and a distance between each first heat dissipating groove assembly and the heat source is equal to a distance between the second heat dissipating groove assemblies corresponding to the first heat dissipating groove assembly and the heat source substantially.

In one embodiment of the present invention, the heat dissipating module further comprises a third heat dissipating fin, disposed in two sides of the combination of the first heat dissipating fins and the second heat dissipating fins.

In one embodiment of the present invention, wherein a projection area of one first heat dissipating groove assembly of the first heat dissipating fin onto the heat source is overlapped with a projection area of another first heat dissipating groove assembly of the first heat dissipating fin onto the heat source, a projection area of one second heat dissipating groove assembly of the second heat dissipating fin onto the heat source is overlapped with a projection area of another second heat dissipating groove assembly of the second heat dissipating fin onto the heat source.

As described in the embodiments of the invention, a plurality of the heat dissipating groove units are configured in at least two heat dissipating fins respectively. The heat dissipating groove units in each heat dissipating fin are not communicated with each other. The heat dissipating groove unit of one heat dissipating fin is communicated with the adjacent heat dissipating groove unit of the heat dissipating fin by a heat dissipating groove unit of another heat dissipating fin when the heat dissipating fins are combined. Therefore, a heat dissipating channel is configured by the heat dissipating groove units of the all heat dissipating fins to heat dissipate for the heat source when the all heat dissipating fins are combined with each other.

Other features and advantages of the invention will be further understood from the further technological features disclosed by the embodiments of the invention wherein there are shown and described embodiments of this invention, simply by way of illustration of best modes to carry out the invention.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1 a schematic view illustrating the heat dissipating module according to one embodiment which is not an embodiment of the present invention.
FIG. 2A and FIG. 2B are schematic views illustrating partial of the heat dissipating fins of the heat dissipating module depicted in FIG. 1.
FIG. 3 is a cross sectional view illustrating partial of the heat dissipating fins depicted in FIG. 1.
FIG. 4 is a cross sectional view illustrating the heat dissipating module depicted in FIG. 1.
FIG. 5 a schematic view illustrating the heat dissipating module according to an embodiment of the present invention.
FIG. 6A and FIG. 6B arc schematic views illustrating partial of the heat dissipating fins of the heat dissipating module depicted in FIG. 5.
FIG. 7A is a cross sectional view illustrating partial of the heat dissipating fins of the heat dissipating module depicted in FIG. 5.
FIG. 7B is a schematic view illustrating a stack of the heat dissipating fins depicted in FIG. 7A.

### DESCRIPTION OF EMBODIMENTS

Other features and advantages of the invention will be further understood from the further technological features disclosed by the embodiments of the invention wherein there are shown and described embodiments of this invention, simply by way of illustration of best modes to carry out the invention.

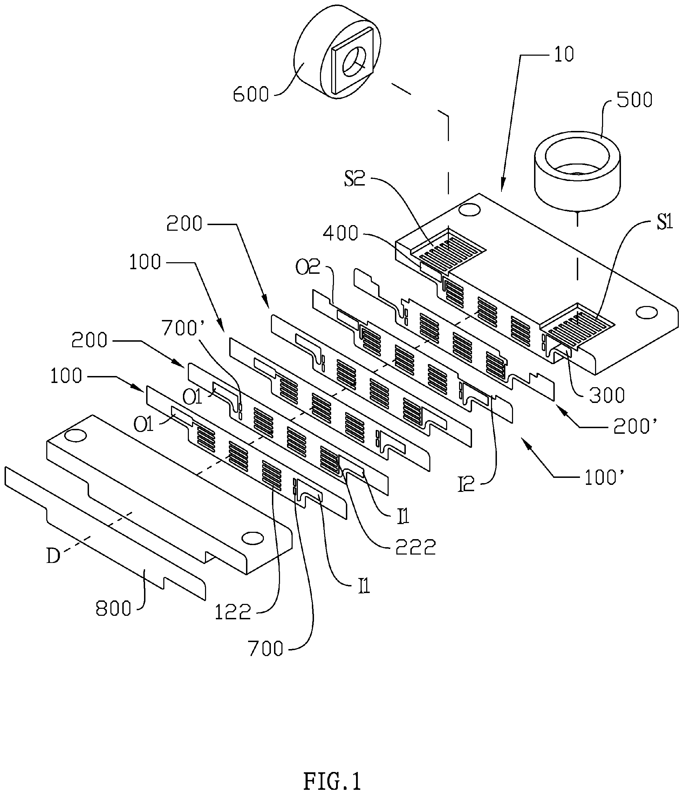

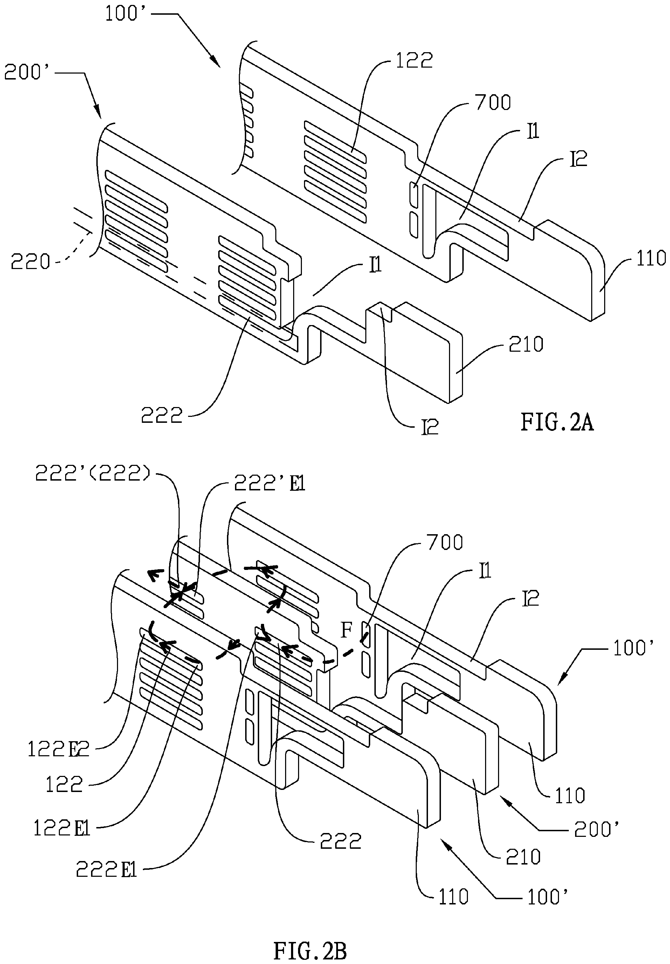

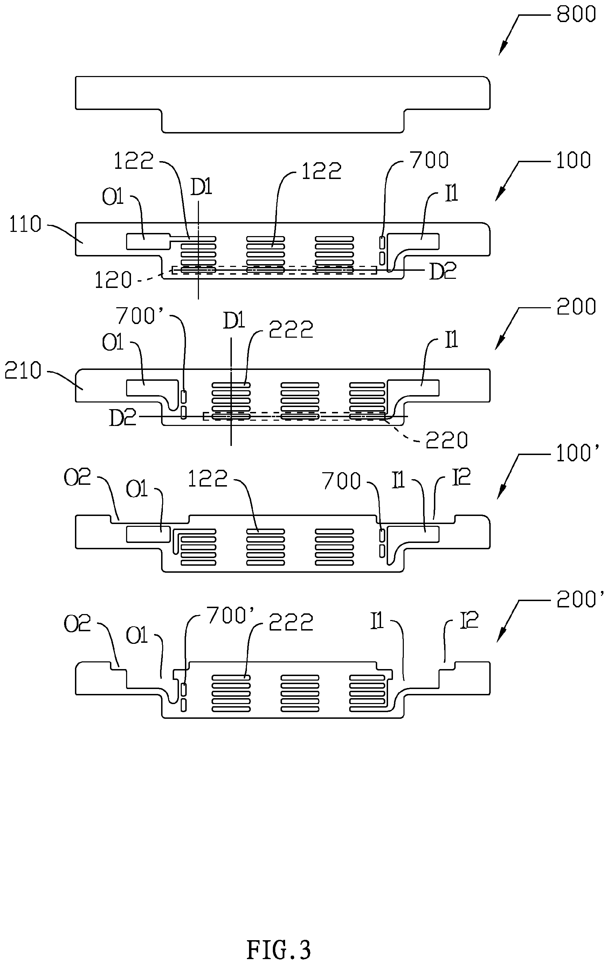

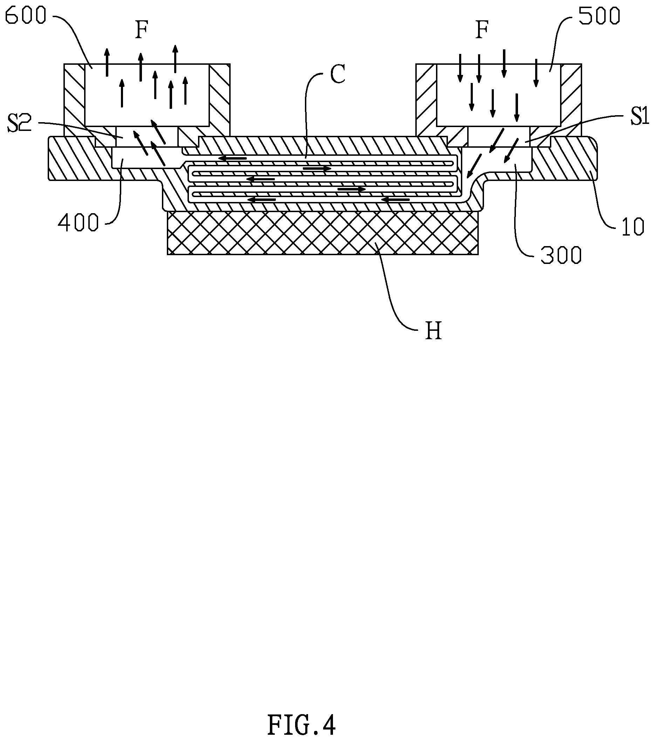

FIG. 1 a schematic view illustrating the heat dissipating module according to one embodiment which is not an embodiment of the present invention, FIG. 2A and FIG. 2B are schematic views illustrating partial of the heat dissipating fins of the heat dissipating module depicted in FIG. 1, FIG. 3 is a cross sectional view illustrating partial of the heat dissipating fins depicted in FIG. 1, and FIG. 4 is a cross sectional view illustrating the heat dissipating module depicted in FIG. 1. Please refer to FIG. 1, FIG. 2A, FIG. 2B, FIG. 3, and FIG. 4, a heat dissipating module 10 of the embodiment is adapted to heat dissipate for a heat source H, the heat dissipating module 10 includes a plurality of first heat dissipating fins 100 and 100' and a plurality of second heat dissipating fins 200 and 200', the first heat dissipating fins 100/100' and the second heat dissipating fins 200/200' are, for example, combined with each other along a fabricating direction D. For example, the first heat dissipating fins 100/100' and the second heat dissipating fins 200/200' can be formed to a block by a compressing technology to be the heat dissipating module 10 of the invention.

As mentioned above, each first heat dissipating fin 100/100' has a first body 110 and a plurality of first heat dissipating groove assemblies 120, the first heat dissipating groove assemblies 120 area arranged in the first body 110 along a the first direction D1. In addition, each first heat dissipating groove assembly 120 has a plurality of first heat dissipating groove units 122, the first heat dissipating groove units 122 are arranged in the first body 110 along a the second direction D2. The heat dissipating module 10 of the embodiment is, for example, fabricated on the heat source H along the first direction D1 to heat dissipate for the heat source H. The first direction D1 and the second direction D2 are, for example, vertical with each other, and the fabricating direction D is vertical to the first direction D1 and the second direction D2 respectively. Similarly, each second heat dissipating fin 200/200' has a second body 210 and a plurality of second heat dissipating groove assemblies 220 arranged in the second body 210 along the first direction D1, each second heat dissipating groove assembly 220 has a plurality of second heat dissipating groove units 222 arranged in the second body 210 along the second direction D2.

In one embodiment which is not an embodiment of the present invention, wherein a projection area of one first heat dissipating groove assembly 120 of the first heat dissipating fin 100/100' onto the heat source is H overlapped with a projection area of another first heat dissipating groove assembly 120 of the first heat dissipating fin 100/100' onto the heat source H, a projection area of one second heat dissipating groove assembly 220 of the second heat dissipating fin 200/200' onto the heat source H is overlapped with a projection area of another second heat dissipating groove assembly 220 of the second heat dissipating fin 200/200' onto the heat source H. A overlapping area between the first heat dissipating groove unit 122 and the second heat dissipating groove unit 222 is smaller than 30% area of the first heat dissipating groove unit 122 or 30% area of the second heat dissipating groove unit 222. The fabricating direction D is not vertical to a top surface of the heat source H, and is parallel to the top surface of the heat source H.

The first heat dissipating groove assemblies 120 and the second heat dissipating groove assemblies 220 are corresponding with each other and configured in the first heat dissipating fins 100/100' and the second heat dissipating fins 200/200' respectively. The distance between each first heat dissipating groove assembly 120 and the heat source H is substantially equal to the distance between the corresponding second heat dissipating groove assembly 220 and the heat source H, such as the first heat dissipating groove assemblies 120 can be communicated to the corresponding second heat dissipating groove assemblies 220. Furthermore, the first heat dissipating fins 100/100' and the second heat dissipating fins 200/200' can be, for example, formed to a block by a compressing technology. The heat dissipating groove units of the first heat dissipating fins 100/100' and the second heat dissipating fins 200/200' are interlaced with each other to allow the heat dissipating groove units to configure a series connection form or a parallel connection form, and a working fluid F is restricted within a channel configured by the communication of the heat dissipating groove units. About the detail design of the first heat dissipating fins 100/100' and the second heat dissipating fins 200/200' , the embodiment will describe as following.

In the heat dissipating module 10 of the embodiment, each first heat dissipating fin 100/100' and each second heat dissipating fin 200/200' have a inlet guiding groove I1 and a outlet guiding groove O1 respectively. When the first heat dissipating fins 100/100' and the second heat dissipating fins 200/200' are combined with each other, the inlet guiding grooves I1 of the first heat dissipating fins 100/100' and the second heat dissipating fins 200/200' are form to be a inlet channel 300, and the outlet guiding grooves O1 of the first heat dissipating fins 100/100' and the second heat dissipating fins 200/200' are form to be a outlet channel 400. Besides, the heat dissipating module 10 further comprises a inlet joint 500 and a outlet joint 600, and the first body 110 of partial of the first heat dissipating fins 100' and the second body 210 of partial of the second heat dissipating fins 200' have a inlet concave 12 and a outlet concave 02.

Similarly, when the first heat dissipating fins 100/100' and the second heat dissipating fins 200/200' are combined with each other, the inlet concaves 12 are formed to be a inlet connecting space S1, the outlet concaves 02 are formed to be a outlet connecting space S2. One side of the inlet connecting space S1 is communicated to the inlet joint 500, and another side of the inlet connecting space S1 is communicated to the inlet channel 300. One side of the outlet connecting space S2 is communicated to the outlet joint 600, and another side of the outlet connecting space S2 is communicated to the outlet channel 400. Each inlet concave 12 is, for example, communicated with the corresponding inlet guiding groove I1, and each outlet concave 02 is, for example, communicated with the corresponding outlet guiding groove O1. Therefore, when the working fluid F flows into the inlet joint 500, the working fluid F can transmit to the inlet channel 300 through the inlet connecting space S1 smoothly, and then the working fluid F flows through the outlet channel 400 and the outlet connecting space S2. Finally, the working fluid F flows out of the heat dissipating module 10 from the outlet joint 600.

Each first heat dissipating groove assembly 120 and each second heat dissipating groove assembly 220 have two end portions respectively, the inlet channel 300 and the outlet channel 400 are adapted to communicate with two of these end portions respectively. As shown in Fig. 2A and Fig. 3, the second heat dissipating groove unit 222 disposed in one end portion of the second heat dissipating groove assembly 220 of the second heat dissipating fin 200/200' is communicated with the inlet guiding groove I1. Similarly, the first heat dissipating groove unit 122 disposed in one end portion of the first heat dissipating groove assembly 120 of the first heat dissipating fin 100/100' is communicated with the outlet guiding groove O1 by the same design.

Furthermore, in the embodiment, a communicating structure 700/700' is configured in the first heat dissipating fin 100/100' or the second heat dissipating fin 200/200' to make two adjacent heat dissipating groove assemblies arranged along the first direction D1 communicate with each other, allowing the working fluid F to flow into the heat dissipating module 10 from the inlet joint 500, and flow out of the heat dissipating module 10 from the outlet joint 600 smoothly. That is to say, when the communicating structure 700 is configured in the first heat dissipating fins 100/100' , two adjacent second heat dissipating groove assemblies 220 of the second heat dissipating fin 200/200' combined with the first heat dissipating fin 100/100' are communicated with each other by the assistance of the communicating structure 700. Similarly, when the communicating structure 700' is configured in the second heat dissipating fins 200/200' , two adjacent first heat dissipating groove assemblies 120 of the first heat dissipating fin 100/100' combined with the second heat dissipating fin 200/200' are communicated with each other by the assistance of the communicating structure 700'.

Specially, when the first heat dissipating fins 100/100' and the second heat dissipating fins 200/200' are combined with each other, one end 122E1 of the first heat dissipating groove unit 122 of each first heat dissipating fin 100' and one end 222E1 of the second heat dissipating groove unit 222 of the second heat dissipating fin 200' adjacent to the first heat dissipating fin 100' are overlapped, and another end 122E2 of the first heat dissipating groove unit 122 and one end 222' E1 of another second heat dissipating groove unit 222'(222) are overlapped(as shown in Fig. 2B and Fig. 3). The second heat dissipating groove unit 222 and the second heat dissipating groove unit 222'(222) overlapped with the first heat dissipating groove unit 122 are adjacent and arranged in the second body 210 along the second direction D2. That is to say, although the second heat dissipating groove unit 222 and the second heat dissipating groove unit 222'(222) of the second heat dissipating fin 200/200' are not communicated, but the second heat dissipating groove unit 222 and the second heat dissipating groove unit 222'(222) adjacent to the second heat dissipating groove unit 222 can be communicated by the assistance of one first heat dissipating groove unit 122 when the first heat dissipating fins 100/100' and the second heat dissipating fins 200/200' are combined, wherein the second heat dissipating groove unit 222 and the second heat dissipating groove unit 222'(222) are arranged along the second direction D2. The above description takes an example of the communication of a plurality of second heat dissipating groove units 222 by the assistance of one first heat dissipating groove unit 122. Similarly, a plurality of first heat dissipating groove units 122 also can be communicated by the assistance of one second heat dissipating groove unit 222.

As such, two adjacent heat dissipating groove units of one heat dissipating fin can be communicated by the assistance of one heat dissipating groove unit of another heat dissipating fin, and two adjacent heat dissipating groove assemblies of one heat dissipating fin also can be communicated by the assistance of the communicating structure of another heat dissipating fin. The embodiment allows the heat dissipating groove units to communicate with each other along the first direction D1 or the second direction D2 when the first heat dissipating fins 100/100' and the second heat dissipating fins 200/200' are combined. That is to say, the inlet channel 300, the first heat dissipating groove assemblies 120 and the second heat dissipating groove assemblies 220 multi-layered within the heat dissipating module 10, and the outlet channel 400 can form a heat dissipating channel C, allowing heat to dissipate from the heat source H. Then, the working fluid F can flow into the heat dissipating module 10 from the inlet joint 500, and flow out of the heat dissipating module 10 from the outlet joint 600.

Worth mentioning is that the inlet channel 300 is, for example, communicated with one end portion of the first heat dissipating groove assembly 120 or the second heat dissipating groove assembly 220 close to the heat source H. The outlet channel 400 is, for example, communicated with one end portion of the first heat dissipating groove assembly 120 or the second heat dissipating groove assembly 220 away from the heat source H. In detail, in order to make the heat dissipating module 10 have a preferred heat dissipating efficiency, the inlet channel 300 is communicated with the heat dissipating groove assembly closed to the bottom of the heat dissipating module 10 in the embodiment. Therefore, heat of the bottom of the heat dissipating module 10 transferred from the heat source H can be removed effectively and directly by the working fluid F having the lower temperature, and the working fluid F with the heat be transmitted to the top of the heat dissipating module 10 through the communicated heat dissipating groove assemblies. The heat dissipation can be performed by the assistance of a nature convection or a forcing convection generated by a fan disposed on the top of the heat dissipating module 10. Therefore, when the heat generated from the heat source H be transmitted to the top of the heat dissipating module 10 with the working fluid F, the heat generated from the heat source H can be removed by the assistance of the nature convection, the forcing convection, or other suitable methods, allowing to decrease the temperature of the working fluid F. Naturally, the working fluid F also can flow out of the heat dissipating module 10 from the outlet joint 600, and process suitable heat removing assignments between the heat dissipating module 10 and the environment, then flow into the heat dissipating module 10 again from the inlet joint 500.

Besides, in the embodiment, one end portion of the first heat dissipating groove unit 122 and one end portion of the second heat dissipating groove unit 222 are, for example, overlapped partially. The following will be described with Fig. 2B. When one end portion of the first heat dissipating groove unit 122 and one end portion of the second heat dissipating groove unit 222 are overlapped partially and the working fluid F flows into the first heat dissipating groove unit 122, the working fluid F be separated by the inner wall of the first heat dissipating groove unit 122 and then flows into two second heat dissipating groove units 222 overlapped with the first heat dissipating groove unit 122 partially. Similarly, when the working fluid F flows into the second heat dissipating groove unit 222, the working fluid F also be separated by the inner wall of the second heat dissipating groove unit and then flows into two first heat dissipating groove unit 122 overlapped with the second heat dissipating groove unit 222 partially. Naturally, when the working fluid F be separated and flows into the two second heat dissipating groove units 222, the working fluid F come across the inner wall thereof and be separated again. The separated working fluid F will be conflux to the first heat dissipating groove unit 122 overlapped partially with the two second heat dissipating groove units 222. Similarly, when the working fluid F be separated and flows into the two first heat dissipating groove units 122, the working fluid F come across the inner wall thereof and be separated again. The separated working fluid F will be conflux to the second heat dissipating groove unit 222 overlapped partially with the two first heat dissipating groove units 122. That is to say, when the working fluid F flows pass each heat dissipating groove unit, the working fluid F will be separated or conflux continuously. In a process of the working fluid F flowing through a plurality of first heat dissipating groove assemblies 120 and second heat dissipating groove assemblies 220 multi-layered in the heat dissipating module 10, the working fluid F have larger contacting area with each first body 110 and each second body 210. Then, a heat exchange among the heat dissipating groove units, the first body 110, and the second body 210 can be performed, allowing to remove the heat transmitted from the heat source H to the heat dissipating fins.

Furthermore, in the heat dissipating module 10 of the embodiment, the working fluid F collides with the inner wall of the end portion of each heat dissipating groove unit to generate a turbulence flow when the working fluid F flow through the heat dissipating groove units interlaced with each other, and then the working fluid F is separated into the heat dissipating groove units adjacent to the foregoing heat dissipating groove unit. The above design can make the temperature of the working fluid F within one region is uniform, allowing to heat exchange stably.

In addition, the heat dissipating module 10 of the embodiment further comprises at least two third heat dissipating fins 800, each third heat dissipating fin 800 just is a board having no holes or crack. Each third heat dissipating fin 800 is disposed in two sides of the combination of the first heat dissipating fins 100 and the second heat dissipating fins 200 to make the heat dissipating module 10 have a closed-type body, allowing to have a more complete design of the heat dissipating channel C.

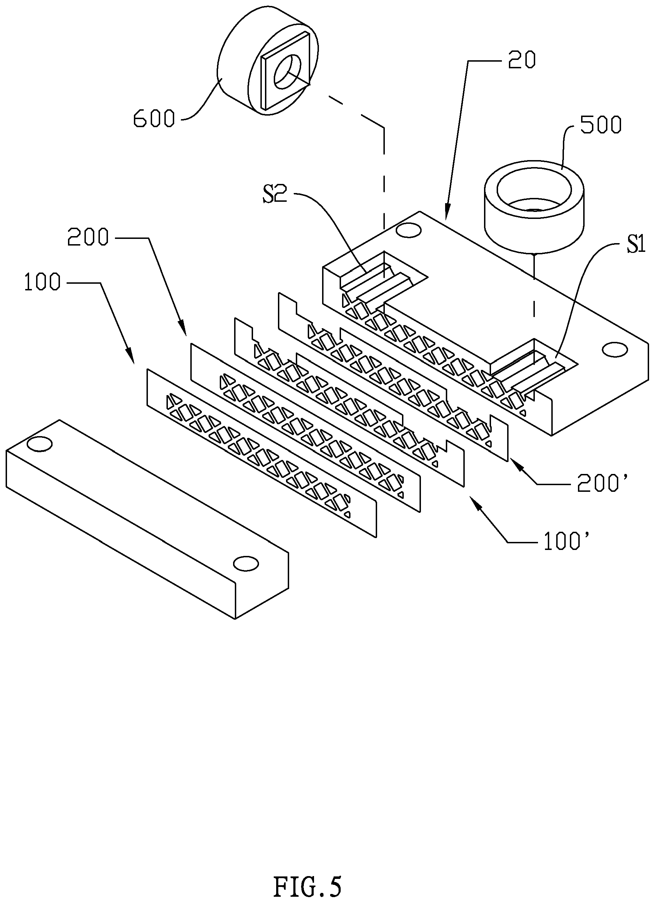

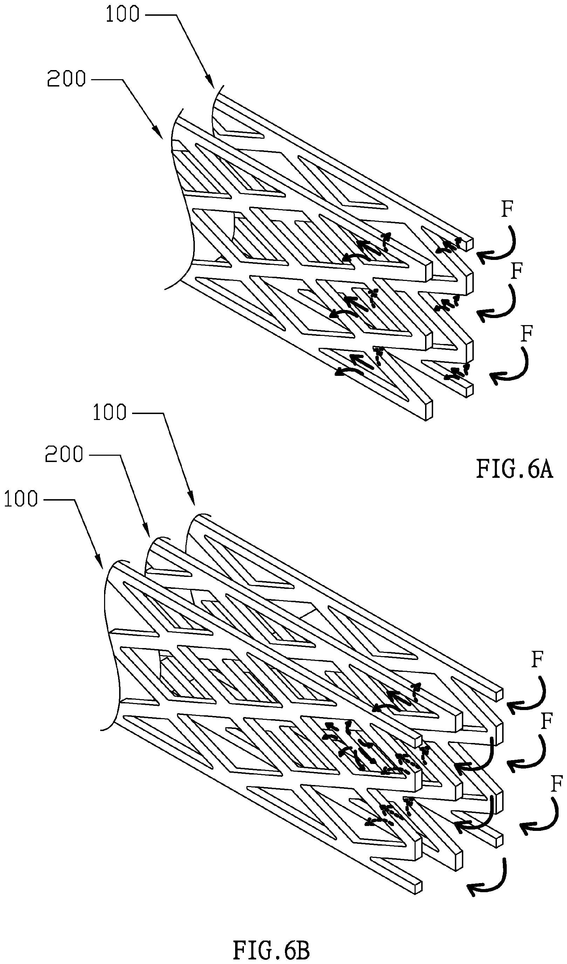

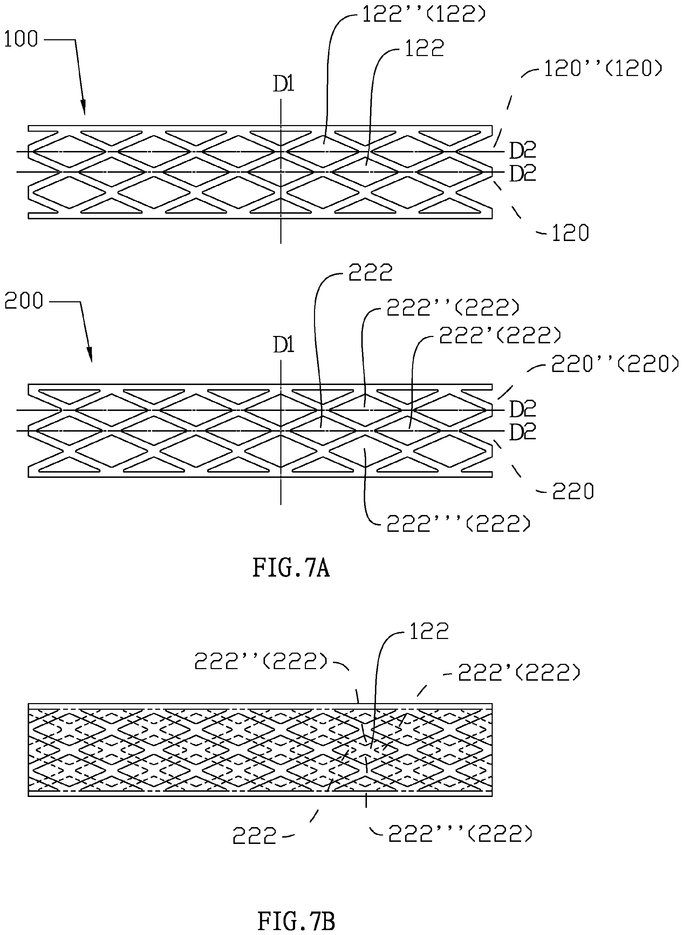

FIG. 5 a schematic view illustrating the heat dissipating module according to an embodiment of the present invention. FIG. 6A and FIG. 6B are schematic views illustrating partial of the heat dissipating fins of the heat dissipating module depicted in FIG. 5. FIG. 7A is a cross sectional view illustrating partial of the heat dissipating fins of the heat dissipating module depicted in FIG. 5. FIG. 7B is a schematic view illustrating a stack of the heat dissipating fins depicted in FIG. 7A. Please refer to FIG. 5, FIG. 6A, FIG. 6B, FIG. 7A and FIG. 7B, the heat dissipating module 20 of this embodiment is similar to the heat dissipating module 10 of the above embodiment. The main difference between the heat dissipating module 20 and the heat dissipating module 10 is that each heat dissipating groove unit of the heat dissipating module 10 in above embodiment is strip-shape structure, and each heat dissipating groove unit of the heat dissipating module 20 in this embodiment is a diamond structure.

In the embodiment of the heat dissipating groove unit being a diamond structure, the first heat dissipating groove units 122 of each first heat dissipating groove assembly 120(a diamond structure arrange extended along the second direction D2 is, for example, shown in Fig. 7A) and the first heal dissipating groove units 122" (122) of another first heat dissipating groove assembly 120" (120) adjacent to the foregoing first heat dissipating groove assembly 120 are interlaced respectively. The second heat dissipating groove units 222 of the second heat dissipating groove assembly 220 and the second heat dissipating groove units 222" (222) of another second heat dissipating groove assembly 220" are interlaced respectively. Besides, the communicating structure of this embodiment is integrated with each heat dissipating groove unit. In detail, due to the heat dissipating groove unit is a diamond structure in the embodiment and two presuppositions (described as following), the two adjacent second heat dissipating groove units (the second heat dissipating groove unit 222 and the second heat dissipating groove unit 222' (222)) arranged along the second direction D2 are communicated with each other by the assistance of the first heat dissipating groove unit 122. Similarly, the two adjacent second heat dissipating groove units(the second heat dissipating groove unit 222"(222) and the second heat dissipating groove unit 222"'(222)) arranged along the first direction D1 are communicated with each other by the assistance of each first heat dissipating groove unit 122. That is to say, the two adjacent second heat dissipating assemblies can be communicated by the assistance of each first heat dissipating groove unit 122. In other word, when the first heat dissipating fin 100 and the second heat dissipating fin 200 as shown in Fig. 7A are combined, the communicating structure integrated with each heat dissipating groove unit of one of the first heat dissipating fin 100 and the second heat dissipating fin 200 can assist the communication among the heat dissipating groove units of the other of the first heat dissipating fin 100 and the second heat dissipating fin 200, wherein the above design is shown in Fig. 7B. Herein, one of the above presuppositions is: the heat dissipating groove units of one heat dissipating groove assembly are interlaced with the heat dissipating groove units of another heat dissipating groove assembly adjacent to the foregoing heat dissipating groove assembly. The other of the above presuppositions is: one end portion of the first heat dissipating groove unit 122 is overlapped partially with one end portion of the second heat dissipating groove unit 222.

Similar to the above embodiment, when the working fluid F flows pass the end portion of the heat dissipating groove units interlaced with each other, the working fluid F will collide with the inner wall of the end portion of each heat dissipating groove unit, and generates a turbulence flow in the embodiment. Then, the working fluid F will be separated into other heat dissipating groove units adjacent to the foregoing heat dissipating groove unit. Worth mentioning is that due to the heat dissipating groove unit is a diamond structure in the embodiment, at least an inclined plane is configure in the inner wall of the heat dissipating groove unit. Therefore, when the working fluid F collide with the inner wall of the end portion of each heat dissipating groove unit, the working fluid F will be separated and flows toward multi-directions. This design is permit to form a turbulence flow with larger degree, and make the temperature of the working fluid F within one region is uniform, allowing to heat exchange stably.

The above description takes an example of the communication of a plurality of second heat dissipating groove units 222 by the assistance of one first heat dissipating groove unit 122. Naturally, a plurality of first heat dissipating groove units 122 also can be communicated with each other by the assistance of one second heat dissipating groove unit 222. In addition to the heat dissipating groove unit of the invention can be the strip-shape structure and the diamond structure described like above embodiments, the heat dissipating groove unit of the invention also can be a round-shape structure, a triangular structure or other suitable structures, including but not limited to these shapes.

As described in the embodiments of the invention, the heat dissipating groove units are configured in at least two heat dissipating fins respectively, wherein the heat dissipating groove units of each heat dissipating fin are not communicated with each other. When these heat dissipating fins are combined, the heat dissipating groove unit of one heat dissipating fin can be communicated with another heat dissipating groove unit of the foregoing heat dissipating fin by the assistance of one heat dissipating groove unit of another heat dissipating fin. Therefore, these heat dissipating groove units configured within the heat dissipating module densely can form a heat dissipating channel C having a preferred heat dissipating efficiency, allowing to heat dissipate for the heat source effectively.

In addition, through two interlaced heat dissipating groove units disposed in two adjacent heat dissipating fins respectively, various shapes of the heat dissipating groove units, a plurality of the heat dissipating groove units communicated with each other and disposed within heat dissipating module by multi-layers configured method, the invention can increase the contacting area between the working fluid and the heat dissipating module substantially, and make the working fluid with a turbulence flow through the heat dissipating groove units interlaced with each other to have a uniform heat exchange between the heat dissipating module and the working fluid stably.

## Claims

1. Heat dissipating module (10), adapted to be disposed on a heat source and to heat dissipate for the heat source (H), the heat dissipating module (10) comprising:
a plurality of first heat dissipating fins (100, 100'), each first heat dissipating fin (100, 100') has a first body (110) and a plurality of first heat dissipating groove assemblies (120, 120") arranged in the first body (110) along a first direction (D1), each first heat dissipating groove assembly (120, 120") has a plurality of first heat dissipating grooves unit (122, 122") arranged in the first body along a second direction (D2); and
a plurality of second heat dissipating fins (200, 200'), each second heat dissipating fin (200, 200') has a second body (210) and a plurality of second heat dissipating groove assemblies (220, 220") arranged in the second body (210) along the first direction (D1), each second heat dissipating groove assembly (220, 220") has a plurality of second heat dissipating groove units (222, 222', 222", 222'") arranged in the second body (210) along the second direction (D2);
wherein the first heat dissipating fins (100, 100') and the second heat dissipating fins (200, 200') are combined with each other, one end (122 E1) of the first heat dissipating groove unit (122, 122") of each first heat dissipating fin (100, 100') is overlapped with one end (222 E1) of one second heat dissipating groove unit (222, 222', 222", 222'") of one second heat dissipating fin (200, 200') adjacent to the first heat dissipating fin (100, 100'), another end (122 E2) of the first heat dissipating groove unit (122, 122") is overlapped with one end (222' E1) of another second heat dissipating groove unit (222, 222', 222", 222"'), and the two second heat dissipating groove units (222, 222', 222", 222"') overlapped with the first heat dissipating groove unit (122, 122") arc adjacent and arranged in the second body (210) along the second direction (D2), wherein each first heat dissipating groove assembly (120, 120") and each second heat dissipating groove assembly (220, 220") have two end portions respectively, and two of the end portions are communicated with an inlet channel (300) and an outlet channel (400) respectively;
wherein at least one of each first heat dissipating fin (100, 100') and each second heat dissipating fin (200, 200') has at least one communicating structure (700, 700'), the communicating structure (700, 700') of each first heat dissipating fin (100, 100') is adapted to communicate with two adjacent second heat dissipating groove assemblies (220, 220") of each second heat dissipating fin (200, 200'), the communicating structure (700, 700') of each second heat dissipating fin (200, 200') is adapted to communicate with two adjacent first heat dissipating groove assemblies (120, 120") of each first heat dissipating fin (100, 100'),
wherein the first heat dissipating groove units (122, 122") of one first heat dissipating groove assembly (120, 120") and the first heat dissipating groove units (122, 122") of another first heat dissipating groove assembly (120, 120") adjacent thereto are interlaced with each other respectively, and the second heat dissipating groove units (222, 222', 222", 222'") of one second heat dissipating groove assembly (220, 220") and the second heat dissipating groove units (222, 222', 222", 222"') of another second heat dissipating groove assembly (220, 220") adjacent thereto are interlaced with each other respectively,
wherein the first heat dissipating grooves unit (122, 122") of each first heat dissipation fin (100, 100") are without overlap and the second heat dissipating grooves unit (222, 222', 222", 222"') of each second heat dissipation fin (200, 200') are without overlap; **characterized in,**
**that** one end portion of the first heat dissipating groove unit (122, 122') is partial overlapped with one end portion of the second heat dissipating groove unit (222, 222', 222", 222'"); and
**that** the first heat dissipating fins (100, 100') are combined with the second heat dissipating fins (200, 200') along a fabricating direction (D) with each other, and the first direction (D1), the second direction (D2), and the fabricating direction (D) are vertical with each other, and
**that** the first body (110) of each first heat dissipating fin (100, 100') has a first heat contacting side, and the second body (210) of each second heat dissipating fin (200, 200') has a second heat contacting side; and
**that** when the first heat dissipating fins (100, 100') and the second heat dissipating fins (200, 200') are combined with each other, constructing a heat contacting surface by these first heat contacting sides and these second heat contacting sides for contacting to the heat source (H); and
**that** each first heat dissipating groove unit (122, 122') and each second heat dissipating groove unit (222, 222', 222", 222'") is a diamond structure, and at least an inclined plane is configured in the inner wall of each first and second heat dissipating groove unit (122, 122', 222, 222', 222",222"')that an included angle between the inclined plane and the heat contacting surface is an acute or obtuse angle.

2. Heat dissipating module as recited in claim 1, wherein the inlet channel, the first heat dissipating groove assemblies, the second heat dissipating groove assemblies, and the outlet channel are communicated with each other to form a heat dissipating channel.

3. Heat dissipating module (10) as recited in claim 1, wherein the communicating structure (700, 700') of each first heat dissipating fin (100, 100') is further communicated with two second heat dissipating groove units (222, 222', 222", 222'") of the second heat dissipating fin (200, 200') adjacent to first heat dissipating fin (100, 100'), and the two second heat dissipating groove units (222, 222', 222", 222'") are adjacent and arranged along the first direction (D1) or the second direction (D2), and the communicating structure (700,700') of each second heat dissipating fin (200, 200') is further communicated with two first heat dissipating groove units (122, 122") of the first heat dissipating fin (100, 100') adjacent to the second heat dissipating fin (200, 200'), and the two first heat dissipating groove units (122, 122") are adjacent and arranged along the first direction (D1) or the second direction (D2).

4. Heat dissipating module as recited in claim 1, wherein each first heat dissipating fin (100, 100') and each second heat dissipating fin (200, 200') have an inlet guiding groove (II) and an outlet guiding groove (02) respectively, the inlet guiding grooves (II) are formed to be the inlet channel (300), the outlet guiding grooves (O1) are formed to be the outlet channel (400).

5. Heat dissipating module (10) as recited in claim 4, further comprises an inlet joint (500) and an outlet joint (600), and the first body (110) of partial of the first heat dissipating fins (100') and the second body (210) of partial of the second heat dissipating fins (200') have an inlet concave (I2) and an outlet concave (O2), the inlet concaves (12) are formed to be an inlet connecting space (S1), the outlet concaves (02) are formed to be an outlet connecting space (S2), one side of the inlet connecting space (S1) is communicated with the inlet joint (500), another side of the inlet connecting space (S1) is communicated with the inlet channel (300), one side of the outlet connecting space S2 is communicated with the outlet joint (600), another side of the outlet connecting space S2 is communicated with the outlet channel (400).

6. Heat dissipating module as recited in claim 5, wherein each inlet concave (I2) is communicated with the corresponding inlet guiding groove (II), each outlet concave (02) is communicated with the corresponding outlet guiding groove (O1).

7. Heat dissipating module (10) as recited in claim 1, wherein the combination of the first heat dissipating fins (100, 100') and the second heat dissipating fins (200, 200') is disposed on the heat source (H) along the first direction (D1), and the inlet channel (300) is communicated with the end portion of the first heat dissipating groove assembly (120, 120") adjacent to the heat source (H) or the end portion of the second heat dissipating groove assembly (200, 220") adjacent to the heat source (H), the outlet channel (400) is communicated with the end portion of the first heat dissipating groove assembly (120, 120") away from the heat source (H) or the end portion of the second heat dissipating groove assembly (220, 220") away from the heat source (H).

8. Heat dissipating module (10) as recited in claim 1, wherein the first heat dissipating groove assemblies (120, 120") and the second heat dissipating groove assemblies (220, 220") are corresponding with each other, and a distance between each first heat dissipating groove assembly (120, 120") and the heat source (H) is equal to a distance between the second heat dissipating groove assemblies (220, 220") corresponding to the first heat dissipating groove assembly (120, 120") and the heat source (H).

9. Heat dissipating module (10) as recited in claim 1, further comprises at least two third heat dissipating fin (800), disposed in two sides of the combination of the first heat dissipating fins (100, 100') and the second heat dissipating fins (200, 200').

10. Heat dissipating module (10) as recited in claim 1, wherein a projection area of one first heat dissipating groove assembly (120, 120") of the first heat dissipating fin (100, 100') onto the heat source (H) is overlapped with a projection area of another first heat dissipating groove assembly (120, 120") of the first heat dissipating fin (100, 100') onto the heat source (H), a projection area of one second heat dissipating groove assembly (220, 220") of the second heat dissipating fin (200, 200") onto the heat source (H) is overlapped with a projection area of another second heat dissipating groove assembly (220, 220") of the second heat dissipating fin (200, 200') onto the heat source (H).

## Patentansprüche

1. Ein Wärmeableitmodul (10), das eingerichtet ist, um auf einer Wärmequelle angeordnet zu sein, und um Wärme der Wärmequelle (H) abzuleiten, wobei das Wärmeableitmodul (10) aufweist:
eine Mehrzahl von ersten Wärmeableitrippen (100, 100'), wobei jede der ersten Wärmeableitrippen (100, 100') einen ersten Körper (110) und eine Mehrzahl von ersten Wärmeableitnut-Anordnungen (120, 120"), die in dem ersten Körper (110) entlang einer ersten Richtung (D1) angeordnet sind, aufweist, wobei jede erste Wärmeableitnut-Anordnung (120, 120") eine Mehrzahl von ersten Wärmeableitnut-Einheiten (122, 122") aufweist, die in dem ersten Körper entlang einer zweiten Richtung (D2) angeordnet sind; und
eine Mehrzahl von zweiten Wärmeableitrippen (200, 200'), wobei jede der zweiten Wärmeableitrippen (200, 200') einen zweiten Körper (210) und eine Mehrzahl von zweiten Wärmeableitnut-Anordnungen (220, 220"), die in dem zweiten Körper (210) entlang der ersten Richtung (D1) angeordnet sind, aufweist, wobei jede der zweiten Wärmeableitnut-Anordnungen (220, 220") eine Mehrzahl von zweiten Wärmeableitnut-Einheiten (222, 222', 222", 222"') aufweist, die in dem zweiten Körper (210) entlang der zweiten Richtung (D2) angeordnet sind;
wobei die ersten Wärmeableitrippen (100, 100') und die zweiten Wärmeableitrippen (200, 200') miteinander kombiniert sind, wobei ein Ende (122 E1) der ersten Wärmeableitnut-Einheit (122, 122") jeder der ersten Wärmeableitrippen (100, 100') ein Ende (222 E1) einer zweiten Wärmeableitnut-Einheit (222, 222', 222", 222"') einer der zweiten Wärmeableitrippen (200, 200'), welche benachbart zu der ersten Wärmeableitrippe (100, 100') ist, überlappt, wobei ein anderes Ende (122 E2) der ersten Wärmeableitnut-Einheit (122, 122") ein Ende (222' E1) einer anderen zweiten Wärmeableitnut-Einheit (222, 222', 222", 222"') überlappt, und wobei die zwei zweiten Wärmeableitnut-Einheiten (222, 222', 222", 222"'), die mit der ersten Wärmeableitnut-Einheit (122, 122") überlappen, benachbart zueinander sind und in dem zweiten Körper (210) entlang der zweiten Richtung (D2) angeordnet sind, wobei jede der ersten Wärmeableitnut-Anordnungen (120, 120") und jede der zweiten Wärmeableitnut-Anordnungen (220, 220") jeweils zwei Endabschnitte aufweist, und wobei zwei der Endabschnitte mit einem Einlasskanal (300), beziehungswiese einem Auslasskanal (400) in Kommunikation stehen;
wobei mindestens eine von jeder der ersten Wärmeableitrippen (100, 100') und von jeder der zweiten Wärmeableitrippen (200, 200') mindestens eine Kommunikationsstruktur (700, 700') aufweist, wobei die Kommunikationsstruktur (700, 700') von jeder der ersten Wärmeableitrippen (100, 100') eingerichtet ist, um mit zwei benachbarten zweiten Wärmeableitnut-Anordnungen (220, 220") jeder der zweiten Wärmeableitrippen (200, 200') zu kommunizieren, wobei die Kommunikationsstruktur (700, 700') von jeder der zweiten Wärmeableitrippen (200, 200') eingerichtet ist, um mit zwei benachbarten ersten Wärmeableitnut-Anordnungen (120, 120") jeder der ersten Wärmeableitrippen (100, 100') zu kommunizieren,
wobei die ersten Wärmeableitnut-Einheiten (122, 122") einer ersten Wärmeableitnut-Anordnung (120, 120") und die ersten Wärmeableitnut-Einheiten (122, 122") einer anderen dazu benachbarten ersten Wärmeableitnut-Anordnung (120, 120") jeweils miteinander verschränkt sind, und wobei die zweiten Wärmeableitnut-Einheiten (222, 222', 222", 222"') einer zweiten Wärmeableitnut-Anordnung (220, 220") und die zweiten Wärmeableitnut-Einheiten (222, 222', 222", 222"') einer anderen dazu benachbarten zweiten Wärmeableitnut-Anordnung (220, 220") jeweils miteinander verschränkt sind,
wobei die erste Wärmeableitnut-Einheit (122, 122") von jeder der ersten Wärmeableitrippen (100, 100") keine Überlappung aufweist, und die zweite Wärmeableitnut-Einheit (222, 222', 222", 222"') jeder der zweiten Wärmeableitrippen (200, 200') keine Überlappung aufweist; **dadurch gekennzeichnet,**
**dass** ein Endabschnitt der ersten Wärmeableitnut-Einheit (122, 122') teilweise von einem Endabschnitt der zweiten Wärmeableitnut-Einheit (222, 222', 222", 222"') überlappt wird; und
**dass** die ersten Wärmeableitrippen (100, 100') mit den zweiten Wärmeableitrippen (200, 200') entlang einer Herstellungsrichtung (D) miteinander kombiniert sind und die erste Richtung (D1), die zweite Richtung (D2) und die Herstellungsrichtung (D) senkrecht zueinander sind, und
**dass** der erste Körper (110) jeder von den ersten Wärmeableitrippen (100, 100') eine erste Wärmekontaktseite aufweist, und der zweite Körper (210) jeder von den zweiten Wärmeableitrippen (200, 200') eine zweite Wärmekontaktseite aufweist; und
**dass**, wenn die ersten Wärmeableitrippen (100, 100') und die zweiten Wärmeableitrippen (200, 200') miteinander kombiniert sind, eine Wärmekontaktfläche durch diese ersten Wärmekontaktseiten und diese zweiten Wärmekontaktseiten gebildet wird, um die Wärmequelle (H) zu kontaktieren; und
**dass** jede der ersten Wärmeableitnut-Einheiten (122, 122') und jede der zweiten Wärmeableitnut-Einheiten (222, 222', 222", 222"') eine Diamantstruktur ist, und zumindest eine geneigte Ebene in der Innenwand jeder von der ersten und zweiten Wärmeableitnut-Einheit (122, 122', 222, 222', 222", 222"') so ausgebildet ist, dass ein eingeschlossener Winkel zwischen der geneigten Ebene und der Wärmekontaktfläche ein spitzer Winkel oder ein stumpfer Winkel ist.

2. Wärmeableitmodul gemäß Anspruch 1, wobei der Einlasskanal, die ersten Wärmeableitnut-Anordnungen, die zweiten Wärmeableitnut-Anordnungen und der Auslasskanal miteinander in Kommunikation stehen, um einen Wärmeableitkanal zu bilden.

3. Wärmeableitmodul (10) gemäß Anspruch 1, wobei die Kommunikationsstruktur (700, 700') von jeder der ersten Wärmeableitrippen (100, 100') ferner mit zwei der zweiten Wärmeableitnut-Einheiten (222, 222', 222", 222"') der zweiten Wärmeableitrippe (200, 200'), die benachbart zu der ersten Wärmeableitrippe (100, 100') ist, in Kommunikation steht, und die zwei zweiten Wärmeableitnut-Einheiten (222, 222', 222", 222"') benachbart zueinander und entlang der ersten Richtung (D1) oder der zweiten Richtung (D2) angeordnet sind, und wobei die Kommunikationsstruktur (700, 700') von jeder der zweiten Wärmeableitrippen (200, 200') ferner mit zwei der ersten Wärmeableitnut-Einheiten (122, 122") der ersten Wärmeableitrippe (100, 100'), die benachbart zu der zweiten Wärmeableitrippe (200, 200') ist, in Kommunikation steht, und die zwei ersten Wärmeableitnut-Einheiten (122, 122") benachbart zueinander und entlang der ersten Richtung (D1) oder der zweiten Richtung (D2) angeordnet sind.

4. Wärmeableitmodul gemäß Anspruch 1, wobei jede der ersten Wärmableitrippen (100, 100') und jede der zweiten Wärmeableitrippen (200, 200') jeweils eine Einlass-Führungsnut (I1) und eine Auslass-Führungsnut (O2) aufweisen, wobei die Einlass-Führungsnute (I1) so gebildet sind, dass sie der Einlasskanal (300) sind, und die Auslass-Führungsnute (O1) so gebildet sind, dass sie der Auslasskanal (400) sind.

5. Wärmeableitmodul (10) gemäß Anspruch 4, ferner aufweisend ein Einlass-Verbindungsteil (500) und ein Auslass-Verbindungsteil (600), und wobei der erste Körper (110) eines Teils der ersten Wärmeableitrippen (100') und der zweite Körper (210) eines Teils der zweiten Wärmeableitrippen (200') eine Einlass-Aussparung (I2) und eine Auslass-Aussparung (O2) aufweisen, wobei die Einlass-Aussparungen (I2) so gebildet sind, dass sie ein Einlass-Verbindungsraum (S1) sind, und die Auslass-Aussparungen (O2) so gebildet sind, dass sie ein Auslass-Verbindungsraum (S2) sind, wobei eine Seite des Einlass-Verbindungsraums (S1) mit dem Einlass-Verbindungsteil (500) in Kommunikation steht, eine andere Seite des Einlass-Verbindungsraums (S1) mit dem Einlasskanal (300) in Kommunikation steht, eine Seite des Auslass-Verbindungsraums (S2) mit dem Auslass-Verbindungsteil (600) in Kommunikation steht, und eine andere Seite des Auslass-Verbindungsraums (S2) mit dem Auslasskanal (400) in Kommunikation steht.

6. Wärmeableitmodul gemäß Anspruch 5, wobei jede Einlass-Aussparung (I2) mit der korrespondierenden Einlass-Führungsnut (I1) in Kommunikation steht, und jede Auslass-Aussparung (O2) mit der korrespondierenden Auslass-Führungsnut (O1) in Kommunikation steht.

7. Wärmeableitmodul (10) gemäß Anspruch 1, wobei die Kombination der ersten Wärmeableitrippen (100, 100') und der zweiten Wärmeableitrippen (200, 200') auf der Wärmequelle (H) entlang der ersten Richtung (D1) angeordnet ist, und wobei der Einlasskanal (300) mit dem benachbart zu der Wärmequelle (H) angeordneten Endabschnitt der ersten Wärmeableitnut-Anordnung (120, 120") oder mit dem benachbart zu der Wärmequelle (H) angeordneten Endabschnitt der zweiten Wärmeableitnut-Anordnung (200, 220") in Kommunikation steht, wobei der Auslasskanal (400) mit dem von der Wärmequelle (H) entfernt angeordneten Endabschnitt der ersten Wärmeableitnut-Anordnung (120, 120") oder mit dem entfernt von der Wärmequelle (H) angeordneten Endabschnitt der zweiten Wärmeableitnut-Anordnung (200, 220") in Kommunikation steht.

8. Wärmeableitmodul (10) gemäß Anspruch 1, wobei die ersten Wärmeableitnut-Anordnungen (120, 120") und die zweiten Wärmeableitnut-Anordnungen (220, 220") miteinander korrespondieren, und wobei ein Abstand zwischen jeder der ersten Wärmeableitnut-Anordnungen (120, 120") und der Wärmequelle (H) gleich einem Abstand zwischen den mit der ersten Wärmeableitnut-Anordnung (120, 120") korrespondierenden zweiten Wärmeableitnut-Anordnungen (220, 220") und der Wärmequelle (H) ist.

9. Wärmeableitmodul (10) gemäß Anspruch 1, ferner aufweisend mindestens zwei dritte Wärmeableitrippen (800), die in zwei Seiten der Kombination aus den ersten Wärmeableitrippen (100, 100') und den zweiten Wärmeableitrippen (200, 200') angeordnet sind.

10. Wärmeableitmodul (10) gemäß Anspruch 1, wobei ein Projektionsbereich einer ersten Wärmeableitnut-Anordnung (120, 120") der ersten Wärmeableitrippe (100, 100') auf die Wärmequelle (H) von einem Projektionsbereich einer anderen ersten Wärmeableitnut-Anordnung (120, 120") der ersten Wärmeableitrippe (100, 100') auf die Wärmequelle (H) überlappt wird, und wobei ein Projektionsbereich einer zweiten Wärmeableitnut-Anordnung (220, 220") der zweiten Wärmeableitrippe (200, 200") auf die Wärmequelle (H) von einem Projektionsbereich einer anderen zweiten Wärmeableitnut-Anordnung (220, 220") der zweiten Wärmeableitrippe (200, 200') auf die Wärmequelle (H) überlappt wird.

## Revendications

1. Module de dissipation de chaleur (10) adapté pour être disposé sur une source de chaleur et pour dissiper la chaleur de la source de chaleur (H), le module de dissipation de chaleur (10) comprenant :
une pluralité de premières ailettes de dissipation de chaleur (100, 100'), chaque première ailette de dissipation de chaleur (100, 100') a un premier corps (110) et une pluralité de premiers ensembles de rainures de dissipation de chaleur (120, 120") agencés dans le premier corps (110) le long d'une première direction (D1), chaque premier ensemble de rainures de dissipation de chaleur (120, 120") a une pluralité de premières unités de rainure de dissipation de chaleur (122, 122") agencées dans le premier corps le long d'une seconde direction (D2) ; et
une pluralité de deuxièmes ailettes de dissipation de chaleur (200, 200'), chaque deuxième ailette de dissipation de chaleur (200, 200') a un second corps (210) et une pluralité de seconds ensembles de rainures de dissipation de chaleur (220, 220") agencés dans le second corps (210) le long de la première direction (D1), chaque second ensemble de rainures de dissipation de chaleur (220, 220") a une pluralité de secondes unités de rainure de dissipation de chaleur (222, 222', 222", 222'") agencées dans le second corps (210) le long de la seconde direction (D2) ;
dans lequel les premières ailettes de dissipation de chaleur (100, 100') et les deuxièmes ailettes de dissipation de chaleur (200, 200') sont combinées entre elles, une extrémité (122 E1) de la première unité de rainure de dissipation de chaleur (122, 122") de chaque première ailette de dissipation de chaleur (100, 100') est recouverte avec une extrémité (222 E1) d'une seconde unité de rainure de dissipation de chaleur (222, 222', 222", 222'") d'une deuxième ailette de dissipation de chaleur (200, 200') adjacente à la première ailette de dissipation de chaleur (100, 100'), une autre extrémité (122 E2) de la première unité de rainure de dissipation de chaleur (122, 122") est recouverte avec une extrémité (222' E1) d'une autre seconde unité de rainure de dissipation de chaleur (222, 222', 222", 222'") et les deux secondes unités de rainure de dissipation de chaleur (222, 222', 222", 222'") recouvertes avec la première unité de rainure de dissipation de chaleur (122, 122") sont adjacentes et agencées dans le second corps (210) le long de la seconde direction (D2), chaque premier ensemble de rainures de dissipation de chaleur (120, 120") et chaque second ensemble de rainures de dissipation de chaleur (220, 220") ayant respectivement deux parties d'extrémité, et deux des parties d'extrémité communiquant avec un canal d'entrée (300) et un canal de sortie (400) respectivement ;
dans lequel au moins l'une parmi chaque première ailette de dissipation de chaleur (100, 100') et chaque deuxième ailette de dissipation de chaleur (200, 200') a au moins une structure de communication (700, 700'), la structure de communication (700, 700') de chaque première ailette de dissipation de chaleur (100, 100') est adaptée pour communiquer avec deux seconds ensembles de rainures de dissipation de chaleur (220, 220") adjacents de chaque deuxième ailette de dissipation de chaleur (200, 200'), la structure de communication (700, 700') de chaque deuxième ailette de dissipation de chaleur (200, 200') est adaptée pour communiquer avec deux premiers ensembles de rainures de dissipation de chaleur (120, 120") adjacents de chaque première ailette de dissipation de chaleur (100, 100'),
dans lequel les premières unités de rainure de dissipation de chaleur (122, 122") d'un premier ensemble de rainures de dissipation de chaleur (120, 120") et les premières unités de rainure de dissipation de chaleur (122, 122") d'un autre premier ensemble de rainures de dissipation de chaleur (120, 120") adjacent à ces dernières, sont entrelacées entre elles respectivement, et les secondes unités de rainure de dissipation de chaleur (222, 222', 222", 222'") d'un second ensemble de rainures de dissipation de chaleur (220, 220") et les secondes unités de rainure de dissipation de chaleur (222, 222', 222", 222'") d'un autre second ensemble de rainures de dissipation de chaleur (220, 220") adjacent à ces dernières sont entrelacées entre elles respectivement,
dans lequel la première unité de rainure de dissipation de chaleur (122, 122") de chaque première ailette de dissipation de chaleur (100, 100") est sans chevauchement et la seconde unité de rainure de dissipation de chaleur (222, 222', 222", 222'") de chaque deuxième ailette de dissipation de chaleur (200, 200') est sans chevauchement ; **caractérisé**
**en ce qu'**une partie d'extrémité de la première unité de rainure de dissipation de chaleur (122, 122') est partiellement recouverte avec une partie d'extrémité de la seconde unité de rainure de dissipation de chaleur (222, 222', 222", 222'") ; et
**en ce que** les premières ailettes de dissipation de chaleur (100, 100') et les deuxièmes ailettes de dissipation de chaleur (200, 200') sont combinées entre elles le long d'une direction de fabrication (D), et la première direction (D1), la seconde direction (D2) et la direction de fabrication (D) sont perpendiculaires entre elles, et
**en ce que** le premier corps (110) de chaque première ailette de dissipation de chaleur (100, 100') a un premier côté de contact de chaleur, et le second corps (210) de chaque deuxième ailette de dissipation de chaleur (200, 200') a un second côté de contact de chaleur ; et
**en ce que** lorsque les premières ailettes de dissipation de chaleur (100, 100') et les deuxièmes ailettes de dissipation de chaleur (200, 200') sont combinées entre elles, elles forment une surface de contact de chaleur par le biais de ces premiers côtés de contact de chaleur et de ces seconds côtés de contact de chaleur pour être en contact avec la source de chaleur (H) ; et
**en ce que** chaque première unité de rainure de dissipation de chaleur (122, 122') et chaque seconde unité de rainure de dissipation de chaleur (222, 222', 222", 222'") est une structure de diamant, et au moins un plan incliné est configuré dans la paroi interne de chaque première et seconde unité de rainure de dissipation de chaleur (122, 122', 222, 222', 222", 222'") de sorte qu'un angle inclus entre le plan incliné et la surface de contact de chaleur est un angle aigu ou obtus.

2. Module de dissipation de chaleur selon la revendication 1, dans lequel le canal d'entrée, les premiers ensembles de rainures de dissipation de chaleur, les seconds ensembles de rainures de dissipation de chaleur et le canal de sortie communiquent entre eux pour former un canal de dissipation de chaleur.

3. Module de dissipation de chaleur (10) selon la revendication 1, dans lequel la structure de communication (700, 700') de chaque première ailette de dissipation de chaleur (100, 100') communique en outre avec deux secondes unités de rainure de dissipation de chaleur (222, 222', 222", 222'") de la deuxième ailette de dissipation de chaleur (200, 200') adjacente à la première ailette de dissipation de chaleur (100, 100') et les deux secondes unités de rainure de dissipation de chaleur (222, 222', 222", 222'") sont adjacentes et agencées le long de la première direction (D1) ou de la seconde direction (D2), et la structure de communication (700, 700') de chaque deuxième ailette de dissipation de chaleur (200, 200') communique en outre avec deux premières unités de rainure de dissipation de chaleur (122, 122") de la première ailette de dissipation de chaleur (100, 100') adjacente à la deuxième ailette de dissipation de chaleur (200, 200') et les deux premières unités de rainure de dissipation de chaleur (122, 122") sont adjacentes et agencées le long de la première direction (D1) ou de la seconde direction (D2).

4. Module de dissipation de chaleur selon la revendication 1, dans lequel chaque première ailette de dissipation de chaleur (100, 100') et chaque deuxième ailette de dissipation de chaleur (200, 200') ont une rainure de guidage d'entrée (I1) et une rainure de guidage de sortie (02) respectivement, les rainures de guidage d'entrée (I1) sont formées pour être le canal d'entrée (300), les rainures de guidage de sortie (O1) sont formées pour être le canal de sortie (400).

5. Module de dissipation de chaleur (10) selon la revendication 4, comprenant en outre un joint d'entrée (500) et un joint de sortie (600), et le premier corps (110) partiel des premières ailettes de dissipation de chaleur (100') et le second corps (210) partiel des deuxièmes ailettes de dissipation de chaleur (200') ont une concavité d'entrée (I2) et une concavité de sortie (02), les concavités d'entrée (I2) sont formées pour être un espace de raccordement d'entrée (S1), les concavités de sortie (02) sont formées pour être un espace de raccordement de sortie (S2), un côté de l'espace de raccordement d'entrée (S1) communique avec le joint d'entrée (500), un autre côté de l'espace de raccordement d'entrée (S1) communique avec le canal d'entrée (300), un côté de l'espace de raccordement de sortie (S2) communique avec le joint de sortie (600), un autre côté de l'espace de raccordement de sortie (S2) communique avec le canal de sortie (400).

6. Module de dissipation de chaleur selon la revendication 5, dans lequel chaque concavité d'entrée (I2) communique avec la rainure de guidage d'entrée (I1) correspondante, chaque concavité de sortie (O2) communique avec la rainure de guidage de sortie (O1) correspondante.

7. Module de dissipation de chaleur (10) selon la revendication 1, dans lequel la combinaison composée des premières ailettes de dissipation de chaleur (100, 100') et des deuxièmes ailettes de dissipation de chaleur (200, 200') est disposée sur la source de chaleur (H) le long de la première direction (D1), et le canal d'entrée (300) communique avec la partie d'extrémité du premier ensemble de rainures de dissipation de chaleur (120, 120") adjacente à la source de chaleur (H) ou bien la partie d'extrémité du second ensemble de rainures de dissipation de chaleur (200, 220") adjacente à la source de chaleur (H), le canal de sortie (400) communique avec la partie d'extrémité du premier ensemble de rainures de dissipation de chaleur (120, 120") éloignée de la source de chaleur (H) ou bien la partie d'extrémité du second ensemble de rainures de dissipation de chaleur (220, 220") éloignée de la source de chaleur (H).

8. Module de dissipation de chaleur (10) selon la revendication 1, dans lequel les premiers ensembles de rainures de dissipation de chaleur (120, 120") et les seconds ensembles de rainures de dissipation de chaleur (220, 220") correspondent l'un à l'autre, et une distance entre chaque premier ensemble de rainures de dissipation de chaleur (120, 120") et la source de chaleur (H) est égale à une distance entre les seconds ensembles de rainures de dissipation de chaleur (220, 220") correspondant au premier ensemble de rainures de dissipation de chaleur (120, 120") et la source de chaleur (H).

9. Module de dissipation de chaleur (10) selon la revendication 1, comprenant en outre au moins deux troisièmes ailettes de dissipation de chaleur (800), disposées sur deux côtés de la combinaison composée des premières ailettes de dissipation de chaleur (100, 100') et des deuxièmes ailettes de dissipation de chaleur (200, 200').

10. Module de dissipation de chaleur (10) selon la revendication 1, dans lequel une zone de saillie d'un premier ensemble de rainures de dissipation de chaleur (120, 120") de la première ailette de dissipation de chaleur (100, 100') sur la source de chaleur (H) est recouverte avec une zone de saillie d'un autre premier ensemble de rainures de dissipation de chaleur (120, 120") de la première ailette de dissipation de chaleur (100, 100') sur la source de chaleur (H), une zone de saillie d'un second ensemble de rainures de dissipation de chaleur (220, 220") de la deuxième ailette de dissipation de chaleur (200, 200") sur la source de chaleur (H) est recouverte avec une zone de saillie d'un autre second ensemble de rainures de dissipation de chaleur (220, 220") de la deuxième ailette de dissipation de chaleur (200, 200') sur la source de chaleur (H).
